(19) Europäisches Patentamt
European Patent Office
Office européen des brevets

(11) Veröffentlichungsnummer: **0 248 299 B1**

(12) **EUROPÄISCHE PATENTSCHRIFT**

(45) Veröffentlichungstag der Patentschrift: **04.03.92**

(51) Int. Cl.$^5$: **G03F 7/00**

(21) Anmeldenummer: **87107543.8**

(22) Anmeldetag: **23.05.87**

# (54) Lichtempfindliches Aufzeichnungselement.

(30) Priorität: **31.05.86 DE 3618373**

(43) Veröffentlichungstag der Anmeldung:
**09.12.87 Patentblatt 87/50**

(45) Bekanntmachung des Hinweises auf die Patenterteilung:
**04.03.92 Patentblatt 92/10**

(84) Benannte Vertragsstaaten:
**BE CH DE ES FR GB IT LI NL**

(56) Entgegenhaltungen:
**EP-A- 0 239 782**
**AU-A- 407 282**
**US-A- 4 370 405**

**MICROELECTRONIC ENGINEERING, Band 3, Nr. 1/4, Dezember 1985, Seiten 321-328, Elsevier Science Publishers B.V. (North-Holland), Amsterdam, NL; M. BOLSEN: "To dye or not to dye - Some aspects of today's resist technology"**

(73) Patentinhaber: **BASF Aktiengesellschaft**
**Carl-Bosch-Strasse 38**
**W-6700 Ludwigshafen(DE)**

(72) Erfinder: **Neumann, Peter, Dr.**
**Franz-Schubert-Strasse 1**
**W-6908 Wiesloch(DE)**
Erfinder: **Wallbillich, Guenter, Dr.**
**Erschigweg 19**
**W-6730 Neustadt(DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).



Rank Xerox (UK) Business Services

## Beschreibung

Die Erfindung betrifft ein lichtempfindliches Aufzeichnungselement, insbesondere für die Herstellung von Druck-, Reliefformen oder Resistmustern, mit einem dimensionsstabilen Träger, einer darauf aufgebrachten, festen lichtempfindlichen Aufzeichnungsschicht sowie gegebenenfalls einer oder mehreren Zwischenschichten zwischen Träger und lichtempfindlicher Aufzeichnungsschicht, welches zumindest in der lichtempfindlichen Aufzeichnungsschicht mindestens eine lichtabsorbierende, nicht-reaktive Verbindung enthält.

Lichtempfindliche Aufzeichnungselemente der genannten Art finden in der Reproduktionstechnik, z.B. bei der Herstellung von Druck- oder Reliefformen sowie von Resistmustern, Anwendung. Als dimensionsstabile Träger dienen üblicherweise Kunststoff-Filme oder -Folien bzw. Stahl- oder Aluminiumbleche; für lichtempfindliche Resistschichten kommen als Träger auch andere Substrate, wie z.B. Kupfer, kupferkaschierte Basiselemente, Leiterplatten, Halbleiterelemente und dergleichen, zur Anwendung. Die einlagig oder auch mehrlagig ausgestaltete lichtempfindliche Aufzeichnungsschicht kann aus einem fotoabbaubaren Material gebildet werden, wodurch sie bei Bestrahlung mit aktinischem Licht in Lösungsmitteln löslich wird, in denen sie vorher unlöslich war; sie kann gleichermaßen auch aus einem fotopolymerisierbaren Gemisch aufgebaut sein, in welchem bei Bestrahlung mit aktinischem Licht durch fotoinitiierte Polymerisation und Vernetzung eine Eigenschaftsdifferenzierung zwischen unbelichteten und belichteten Bereichen erzeugt wird, die für die Entwicklung der Druckoder Reliefform bzw. des Resistmusters ausgenützt werden kann. Vielfach enthalten die lichtempfindlichen Aufzeichnungselemente, insbesondere wenn sie zur Herstellung von Druck- oder Reliefformen eingesetzt werden, zwischen Träger und lichtempfindlicher Aufzeichnungsschicht eine oder mehrere Zwischenschichten, die z.B. als Haft- und/oder Lichthofschutzschichten ausgebildet und gleichermaßen lichtempfindlich oder lichtunempfindlich sein können.

Zur Steuerung der fotochemischen Prozesse bei der Bildherstellung, beispielsweise zur Erzielung einer bestimmten, gewünschten Reliefstruktur, enthalten die bekannten lichtempfindlichen Aufzeichnungselemente in aller Regel in der lichtempfindlichen Aufzeichnungsschicht und/oder - sofern vorhanden - in der oder mindestens einer der Zwischenschichten Farbstoffe oder Pigmente, die im Wellenlängenbereich des für die lichtempfindliche Aufzeichnungsschicht aktinischen Lichtes absorbieren (vgl. u.a. US-A-2 791 504, GB-A-1 001 831, DE-A-26 58 422, DE-A-22 02 360, US-A-4 173 673 und Microelectronic Engineering, Band 3, Nr. 1/4, Dezember 1985, Seiten 321 bis 328, Elsevier Science Publishers B.V., Amsterdam, Netherlands). Pigmente haben hierbei den Nachteil, daß sie häufig unerwünschte Lichtstreuung verursachen oder zum Teil nur schwierig in homogener, gleichmäßiger Verteilung in der betreffenden Schicht eingemischt werden können. Daher werden für die Steuerung der Belichtungs- und anderen fotochemischen Eigenschaften der lichtempfindlichen Aufzeichnungselemente vielfach Farbstoffe bevorzugt. Es hat sich jedoch herausgestellt, daß viele der an sich in Betracht kommenden und für diesen Zweck auch beschriebenen Farbstoffe nicht migrationsbeständig sind, d.h., sind solche Farbstoffe in den verschiedenen Schichten der lichtempfindlichen Aufzeichnungselemente in abgestufter Konzentration enthalten, so wandern die Farbstoffe entsprechend dem Konzentrationsgefälle unter Ausgleich der verschiedenen Konzentrationen und somit auch in aller Regel unter Änderung bzw. Verlust der gezielt eingestellten fotochemischen Eigenschaften der lichtempfindlichen Aufzeichnungselemente. Es sind zwar auch schon nicht-wandernde Farbstoffe für lichtempfindliche Aufzeichnungselemente beschrieben worden; die Farbstoffe, die tatsächlich die gewünschte Migrationsbeständigkeit aufweisen, sind jedoch nach Art und Anzahl sehr gering.

Aus der AU-A 407 282 ist ein Verfahren zur Herstellung von Filmen des Diazotyps für fotographische Zwecke bekannt, bei dem zwischen Träger und lichtempfindlicher Diazo-Aufzeichnungsschicht eine Zwischenschicht aus einer anionischen, nicht-farbigen, grün-blau bis blau-violett fluoreszierenden Verbindungen zur Ausbildung besserer allmählicher Abstufungen bei der Bild-Herstellung gebildet wird. Als fluoreszierende Verbindungen werden solche vom Stilben-Typ mit entsprechenden Substituenten genannt. Der Einsatz dieser Verbindungen in lichtempfindlichen Aufzeichnungsschichten ist in dieser Druckschrift nicht angesprochen. Es besteht nach wie vor Bedarf an weiteren lichtempfindlichen Aufzeichnungselementen, in denen die fotochemischen Prozesse bei deren Belichtung gezielt in verschiedenartiger Weise gesteuert und kontrolliert werden.

Aufgabe der vorliegenden Erfindung war es dementsprechend, lichtempfindliche Aufzeichnungselemente der in Rede stehenden Art mit sehr guten Belichtungs- und Reproduktionseigenschaften und hoher Lagerbeständigkeit aufzuzeigen, die zumindest in ihrer lichtempfindlichen Aufzeichnungsschicht sowie gegebenenfalls auch in einer eventuell zwischen dimensionsstabilem Träger und lichtempfindlicher Aufzeichnungsschicht vorhandenen Zwischenschicht eine lichtabsorbierende, nicht-reaktive Verbindung in einer für eine gezielte Einstellung und Steuerung der fotochemischen Eigenschaften dieser lichtempfindlichen Aufzeichnungselemente geeigneten Art und Weise enthalten, wobei die lichtabsorbierende, nicht-reaktive

Verbindung in dem lichtempfindlichen Aufzeichnungselement in über die Schichtdicke hinweg abgestufter Konzentration enthalten sein kann, ohne daß es selbst bei langen Lagerzeiten zu einer Migration der lichtabsorbierenden, nicht-reaktiven Verbindung und einer damit bedingten Änderung der fotochemischen und Belichtungseigenschaften der lichtempfindlichen Aufzeichnungselemente kommt.

Es wurde nun überraschend gefunden, daß diese Aufagabe durch lichtempfindliche Aufzeichnungselemente gelöst wird, die zumindest in ihrer lichtempfindlichen Aufzeichnungsschicht spezielle, lichtabsorbierende, nicht-reaktive Verbindungen der nachstehend näher definierten Art in über die Schichtdicke hinweg abgestufter Konzentration enthalten.

Gegenstand der Erfindung ist dementsprechend ein lichtempfindliches Aufzeichnungselement, insbesondere für die Herstellung von Druck-, Reliefformen oder Resistmustern, mit

(a) einem dimensionsstabilen Träger,

(b) einer auf dem Träger aufgebrachten, festen lichtempfindlichen Aufzeichnungsschicht,

sowie gegebenenfalls

(c) einer oder mehreren Zwischenschichten zwischen dem Träger und der lichtempfindlichen Aufzeichnungsschicht,

das zumindest in der lichtempfindlichen Aufzeichnungsschicht mindestens eine lichtabsorbierende, nicht-reaktive Verbindung enthält. Das erfindungsgemäße lichtempfindliche Aufzeichnungselement ist dadurch gekennzeichnet, daß in der lichtempfindlichen Aufzeichnungsschicht als lichtabsorbierende, nicht-reaktive Verbindung mindestens eine Verbindung der allgemeinen Formel (I)

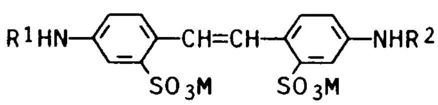

(I)

in über die Schichtdicke hinweg abgetufter Konzentration enthalten ist, wobei in der allgemeinen Formel (I) bedeuten

M: ein Wasserstoffatom bzw. Proton, ein Alkalimetall-Kation, das Ammonium- oder ein Amin-Kation und

$R^1$,$R^2$: gleich oder verschieden, jeweils einen substituierten s-Triazinring.

Unter lichtabsorbierenden, nicht-reaktiven Verbindungen werden im Rahmen dieser Erfindung solche Verbindungen verstanden, die im Wellenlängenbereich des für die lichtempfindliche Aufzeichnungsschicht aktinischen Lichts absorbieren, d.h. im aktinischen Wellenlängenbereich eine oder mehrere starke Absorptionsbanden aufweisen, ohne jedoch bei Bestrahlung mit aktinischem Licht eine photoinduzierte chemische Reaktion einzugehen. Auch wenn die in den lichtempfindlichen Aufzeichnungselementen erfindungsgemäß einzusetzenden lichtabsorbierenden, nicht-reaktiven Verbindungen der allgemeinen Formel (I) ihr Absorptionsmaximum unterhalb von 400 nm im UV-Bereich haben und somit in der Regel nicht farbig sind, vielmehr wegen ihrer Fluoreszenzeigenschaften optisch aufhellend wirken, sollen sie im Rahmen dieser Erfindung nachfolgend der Einfachheit halber dennoch als Farbstoffe bezeichnet werden.

Es hat sich überraschenderweise gezeigt, daß die erfindungsgemäß einzusetzenden, speziellen lichtabsorbierenden Verbindungen der allgemeinen Formel (I) in den lichtempfindlichen Aufzeichnungselementen äußerst migrationsbeständig sind und mit großem Vorteil zur Einstellung der Lichtempfindlichkeit, der Belichtungseigenschaften und zur sonstigen Steuerung der fotochemischen Prozesse in den lichtempfindlichen Aufzeichnungsschichten bei deren Belichtung mit aktinischem Licht eingesetzt werden können. Die erfindungsgemäßen lichtempfindlichen Aufzeichnungselemente zeichnen sich durch eine hohe Lagerfähigkeit aus, ohne daß hierbei die gewünschten und speziell eingestellten Belichtungs- und Bildreproduktionseigenschaften beeinträchtigt oder verändert werden. Wegen der Fluoreszenzwirkung der erfindungsgemäß in den lichtempfindlichen Aufzeichnungsschichten enthaltenen Farbstoffe der allgemeinen Formel (I) lassen sich hiermit insbesondere vorteilhaft z.B. die Reliefstruktur und Flankenform bei der Herstellung von Druck- oder Reliefformen einstellen. Es war dabei überraschend, daß sich die fluoreszierenden Verbindungen der allgemeinen Formel (I) überhaupt als lichtabsorbierende Verbindungen zur Steuerung der Photoeigenschaften in lichtempfindlichen Aufzeichnungsschichten der in Rede stehenden Art eignen.

Die Einstellung gezielter Belichtungs- und Bildreproduktionseigenschaften der erfindungsgemäßen lichtempfindlichen Aufzeichnungselemente bzw. die gezielte Steuerung der fotochemischen Prozesse in den erfindungsgemäßen lichtempfindlichen Aufzeichnungselementen bei deren Bestrahlung mit aktinischem Licht mittels der erfindungsgemäß einzusetzenden Farbstoffe der allgemeinen Formel (I) kann dabei in mannigfacher Weise erfolgen.

Beispielsweise ist es möglich, daß die erfindungsgemäß einzusetzenden Farbstoffe der allgemeinen Formel (I) allein in der lichtempfindlichen Aufzeichnungsschicht der lichtempfindlichen Aufzeichnungselemente in einem über die Dicke der lichtempfindlichen Aufzeichnungsschicht hinweg verlaufenden Konzentrationsgefälle vorliegen. Die Konzentration der Farbstoffe der allgemeinen Formel (I) kann dabei von der äußeren Oberfläche der lichtempfindlichen Aufzeichnungsschicht zum Träger hin zuoder auch abnehmen. Die lichtempfindliche Aufzeichnungsschicht kann dabei einlagig ausgebildet sein oder auch aus mehreren Lagen mit differenzierten Eigenschaften und unterschiedlicher Konzentration der Farbstoffe der allgemeinen Formel (I) bestehen.

In lichtempfindlichen Aufzeichnungselementen, die zwischen dimensionsstabilem Träger und lichtempfindlicher Aufzeichnungsschicht eine Zwischenschicht, beispielsweise eine Haft- und/oder Lichthofschutzschicht, enthalten, kann der erfindungsgemäß einzusetzende Farbstoff der allgemeinen Formel (I) in abgestufter Konzentration sowohl in der lichtempfindlichen Aufzeichnungsschicht als auch in der Zwischenschicht vorliegen. Im letztgenannten Fall wird in der Regel die Konzentration des erfindungsgemäß einzusetzenden Farbstoffs der allgemeinen Formel (I) in der Zwischenschicht höher sein als in der lichtempfindlichen Aufzeichnungsschicht. Es ist selbstverständlich auch möglich, die Belichtungseigenschaften der erfindungsgemäßen lichtempfindlichen Aufzeichnungselemente bzw. die Steuerung der fotochemischen Prozesse in den erfindungsgemäßen lichtempfindlichen Aufzeichnungselementen bei deren Belichtung mit aktinischem Licht nicht nur über die Konzentration, sondern auch über die Art der Farbstoffe der allgemeinen Formel (I) zu steuern, indem man z.B. in den verschiedenen Schichten der lichtempfindlichen Aufzeichnungselemente bzw. den einzelnen Lagen einer mehrlagig ausgestalteten lichtempfindlichen Aufzeichnungsschicht unterschiedlich absorbierende Farbstoffe der erfindungsgemäß zu verwendenden Art inkorporiert.

Bei den erfindungsgemäß einzusetzenden Farbstoffen, die in der lichtempfindlichen Aufzeichnungsschicht und einer zwischen dimensionsstabilem Träger und lichtempfindlicher Aufzeichnungsschicht gegebenenfalls vorhandenen Zwischenschicht der lichtempfindlichen Aufzeichnungselemente enthalten sein können, handelt es sich um Verbindungen der vorstehend angegebenen allgemeinen Formel (I). Hierin steht M für ein Wasserstoffatom bzw. Proton, ein Alkalimetall-Kation, insbesondere das Lithium-, Natrium- oder Kalium-Kation, das $NH_4^+$ -Kation oder ein Amin-Kation, wie insbesondere ein $H_2N^{\oplus}R^3R^4$- oder ein $HN^{\oplus}R^3R^4R^5$-Kation, worin die Reste $R^3$ und $R^4$ bzw. $R^3$, $R^4$ und $R^5$ gleich oder verschieden sein können und jeweils für eine Alkylgruppe, insbesondere mit 1 bis 4 C-Atomen, oder eine Hydroxyalkylgruppe, insbesondere mit 2 bis 3 C-Atomen, stehen. Vorzugsweise bedeutet M ein Wasserstoffatom bzw. Proton.

Die Reste $R^1$ und $R^2$ in der allgemeinen Formel (I) können gleich oder verschieden sein, sind jedoch in aller Regel gleich. Sie stehen, jeder für sich, für einen substituierten s-Triazinring. Als Substituenten für die s-Triazin-Reste kommen z.B. in Betracht: eine $NH_2$-Gruppe, eine Alkylaminogruppe, eine Dialkylamino-Gruppe, eine Hydroxyalkylamino-Gruppe, eine Bis(hydroxyalkyl)amino-Gruppe, eine gegebenenfalls substituierte Cycloalkylamino-Gruppe, eine Morpholino-, Pyrrolidino-, Piperidino- oder gegebenenfalls substituierte Piperazino-Gruppe, eine Arylamino-Gruppe, in der der Arylrest gegebenenfalls substituiert sein kann, eine Alkoxyalkylamino-Gruppe, eine Cyanalkylamino-Gruppe, eine gegebenenfalls substituierte Alkyl-aryl-amino-Gruppe, eine Hydroxy-Gruppe, eine gegebenenfalls substituierte Alkyloxygruppe, eine gegebenenfalls substituierte Aryloxygruppe, eine gegebenenfalls substituierte Alkylthiogruppe, eine gegebenenfalls substituierte Arylthiogruppe und andere. Vorzugsweise kommen als Substituenten für die s-Triazinringe gegebenenfalls substituierte Aminogruppen, insbesondere die $NH_2$-Gruppe, eine Alkylamino- oder DialkylaminoGruppe, insbesondere mit 1 bis 4 C-Atomen im Alkylrest, eine (Hydroxyalkyl)amino- oder Di (hydroxyalkyl)amino-Gruppe, insbesondere mit 2 oder 3 C-Atomen im Hydroxyalkylrest, oder eine Arylamino-Gruppe, insbesondere eine Phenylamino- oder Naphthylamino-Gruppe, wobei der Arylrest gegebenenfalls, insbesondere durch Alkylreste, vorzugsweise mit 1 bis 4 C-Atomen, und/oder $-SO_3M$-Reste (mit M gleich der vorstehend angegebenen Bedeutung), substituiert sein kann, in Betracht. Als sehr günstig für den erfindungsgemäßen Einsatz haben sich die Farbstoffe der allgemeinen Formel (I) erwiesen, in denen jeder der s-Triazinringe der Reste $R^1$ und $R^2$ durch einen oder vorzugsweise zwei substituierte Amino-Reste, beispielsweise der vorstehend genannten Art, substituiert ist. Besonders bevorzugt sind dabei die Verbindungen der allgemeinen Formel (I), in denen die Reste $R^1$ und $R^2$, jeder für sich, einen s-Triazinring darstellen, der sowohl durch eine Dialkylamino- oder eine Di(hydroxyalkyl)amino-Gruppe als auch durch eine gegebenenfalls substituierte Arylamino-Gruppe substituiert ist. Unter den Arylamino-Substituenten für die s-Triazinringe sind hierbei die Phenylamino-Gruppen von besonderer Bedeutung, deren Phenylrest mit ein oder mehreren $-SO_3M$-Resten substituiert ist, wobei M die weiter oben angegebene Bedeutung zukommt und insbesondere für ein Wasserstoffatom bzw. Proton steht.

Als Beispiele für die erfindungsgemäß einzusetzenden Farbstoffe der allgemeinen Formel (I) seien die Verbindungen der nachfolgenden Formeln (II) bis (XVIII) genannt.

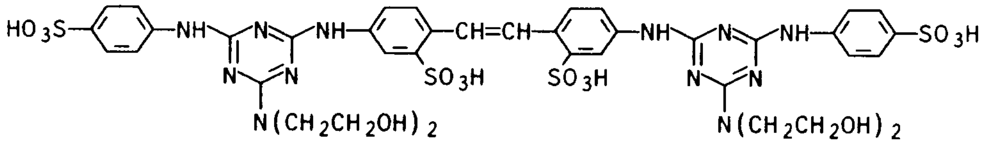

(II)

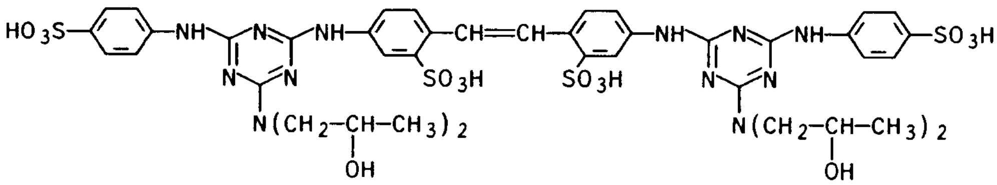

(III)

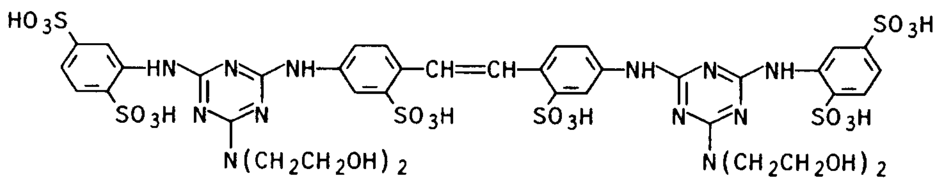

(IV)

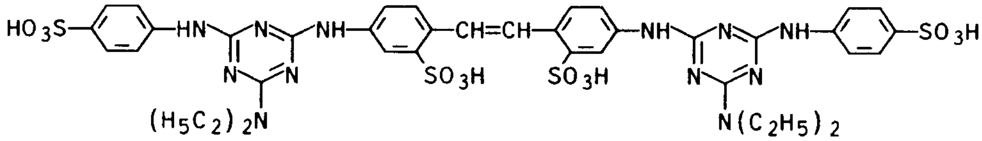

(V)

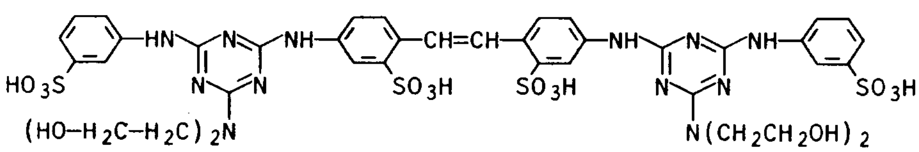

(VI)

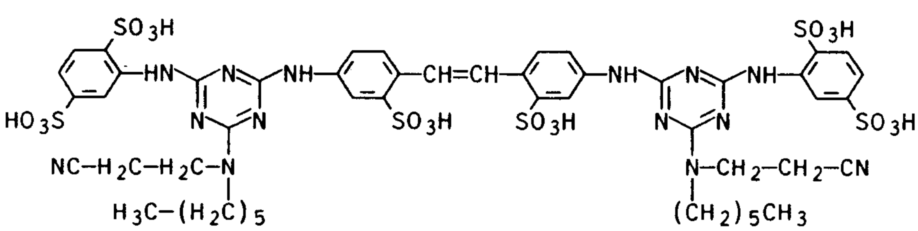

(VII)

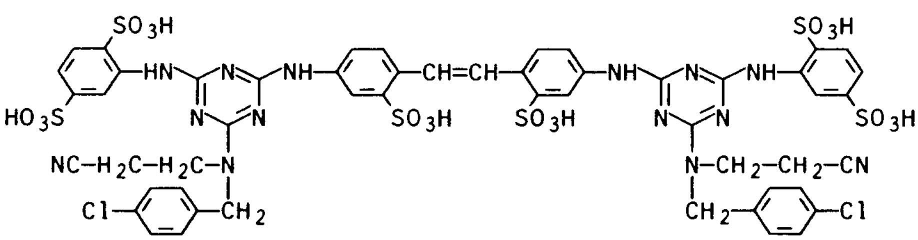

(VIII)

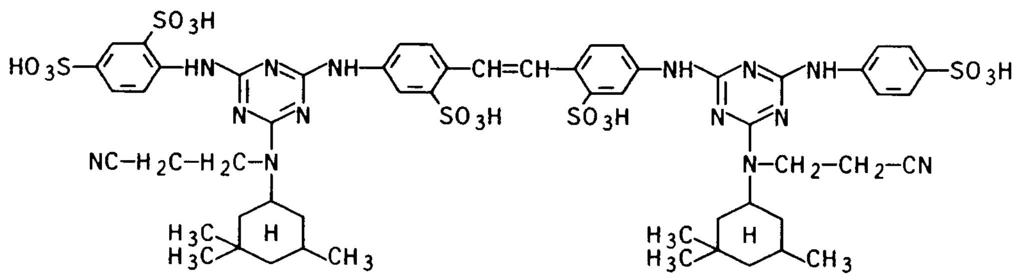

(IX)

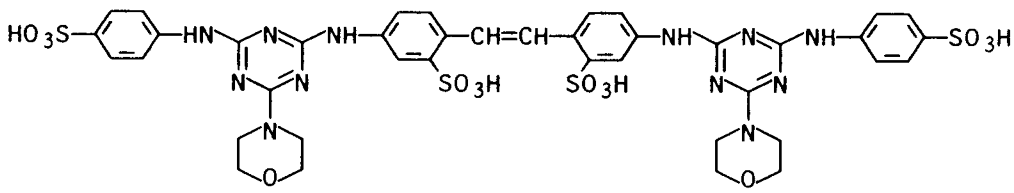

(X)

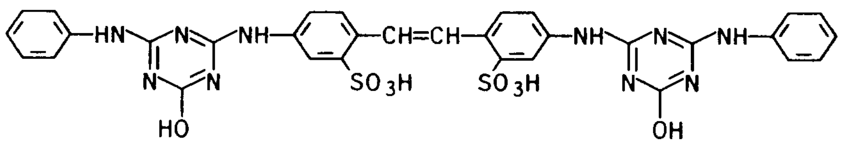

(XI)

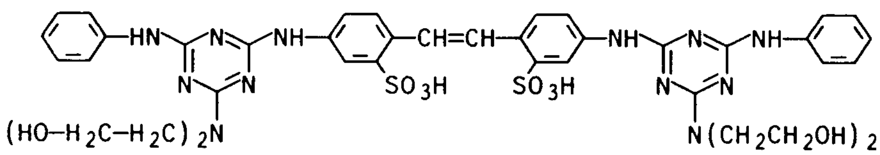

(XII)

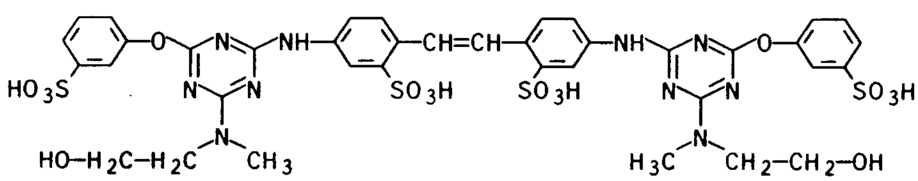

(XIII)

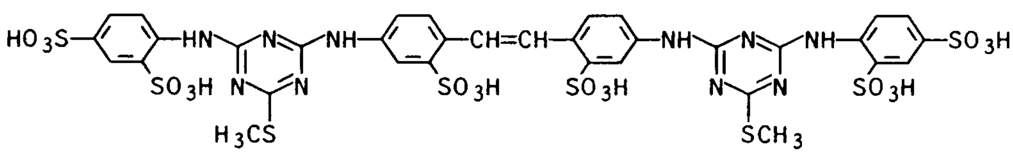

(XIV)

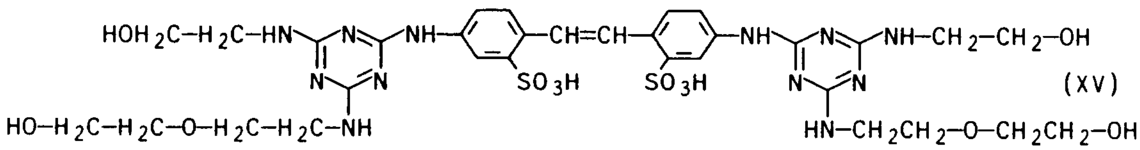

(XV)

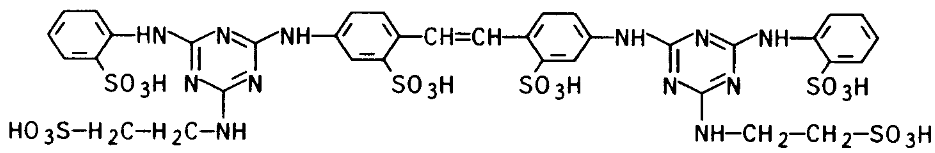

(XVI)

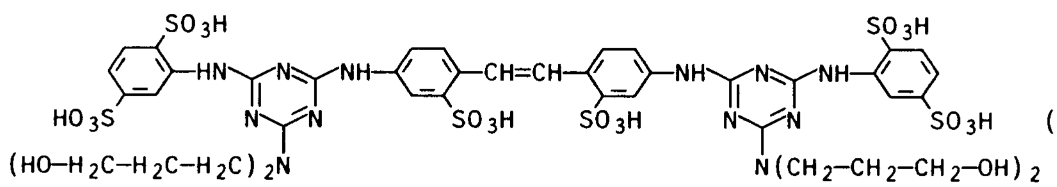

(XVII)

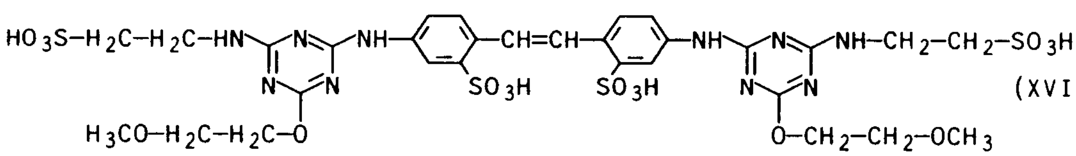

(XVIII)

Die erfindungsgemäß einzusetzenden Farbstoffe der allgemeinen Formel (I) können nach den für diese Verbindungen üblichen und literaturbekannten Methoden hergestellt werden.

Die erfindungsgemäß einzusetzenden Farbstoffe der allgemeinen Formel (I) sind in den lichtempfindlichen Aufzeichnungselementen in zur Einstellung der gewünschten Fotoeigenschaften wirksamen Mengen vorhanden, wie sie an sich bekannt und üblich sind bzw. durch einige wenige, einfache Versuche leicht ermittelt werden können. Die Konzentration der Farbstoffe der allgemeinen Formel (I) in der bzw. den genannten Schichten ist dabei unter anderem dem Verwendungszweck der lichtempfindlichen Aufzeichnungselemente (z.B. Einsatz im Hoch-, Flexo-oder Tiefdruck oder als Fotoresist), der Stärke der einzelnen Schichten, dem Aufbau der lichtempfindlichen Aufzeichnungselemente (ein- oder mehrlagige lichtempfindliche Aufzeichnungsschicht, Zwischenschichten etc.)
und auch der Art und Intensität der bei der Anwendung der lichtempfindlichen Aufzeichnungselemente zum Einsatz gelangenden Lichtquellen anzupassen und kann demzufolge in weiten Grenzen variieren.

Zu dem Aufbau der erfindungsgemäßen lichtempfindlichen Aufzeichnungselemente ist im übrigen folgendes zu sagen:
Als Träger kommen die für lichtempfindliche Aufzeichnungselemente der in Rede stehenden Art üblichen und an sich bekannten, dimensionsstabilen, starren oder vorzugsweise flexiblen Schichtträger in Betracht, deren Auswahl vom Verwendungszweck der lichtempfindlichen Aufzeichnungselemente mitbestimmt wird. So werden für die Herstellung von Druck- oder Reliefformen als dimensionsstabile Träger insbesondere Kunststoff-Filme oder -Folien, insbesondere aus Polyestern, wie z.B. Polyethylenterephthalat, sowie auch metallische Schichtträger, beispielsweise Stahl- oder Aluminium-Bleche, eingesetzt. In diesen Fällen ist die lichtempfindliche Aufzeichnungsschicht haftfest auf dem dimensionsstabilen Träger aufgebracht. Hierzu können die Trägermaterialien gegebenenfalls in an sich bekannter Weise, z.B. mechanisch, chemisch, elektrochemisch und/oder durch Versehen mit einer Haftgrundierung, vorbehandelt sein. Für Fotoresistfilme und Schichtübertragungsmaterialien finden als Trägermaterialien vorzugsweise Kunststoff-Filme oder -Folien, insbesondere Polyester-Folien, z.B. aus Polyethylenterephthalat, Verwendung, die eine mäßige Haftung zu der lichtempfindlichen Aufzeichnungsschicht haben und nach dem Auflaminieren bzw. Aufkaschieren der lichtempfindlichen Aufzeichnungsschicht auf ein Substrat von dieser - vor oder nach der Belichtung mit aktinischem Licht - abgezogen werden können. Für die Herstellung von Resistmustern kann

die lichtempfindliche Aufzeichnungsschicht auch direkt auf das zu schützende sowie gegebenenfalls dauerhaft zu modifizierende Substrat aufgebracht werden, welches dann als Träger für die lichtempfindliche Aufzeichnungsschicht fungiert. Als Substrate für lichtempfindliche Resistschichten kommen beispielsweise Kupferbleche, kupferkaschierte Basismaterialien, Keramiksubstrate, die mit metallischen oder metalloxidischen Schichten beschichtet sind, Halbleiterelemente, Silicium-Wafer und dergleichen in Betracht.

Die lichtempfindliche Aufzeichnungsschicht der erfindungsgemäßen lichtempfindlichen Aufzeichnungselemente kann positiv oder negativ arbeitend sein und grundsätzlich aus beliebigen, für solche Schichten an sich bekannten Materialien gebildet werden. Beispielsweise kommen für die lichtempfindliche Aufzeichnungsschicht die bekannten fotoabbaubaren Materialien bzw. solche Materialien, die bei Bestrahlung mit aktinischem Licht in Lösungsmitteln löslich werden, in denen sie zuvor unlöslich waren, in Betracht. Hierzu gehören beispielsweise die positiv arbeitenden Aufzeichnungsmaterialien auf Basis von o-Chinondiazid-Gruppen enthaltenden Verbindungen, wie sie u.a. in der DE-A-20 28 903, der DE-A-22 36 914, der US-A-3 782 939, der US-A-3 837 860 und der US-A-4 193 797 beschrieben sind. Hierzu gehören insbesondere auch die lichtempfindlichen Aufzeichnungsmaterialien, welche als lichtempfindliche Komponente eine Verbindung mit mindestens zwei aromatischen und/oder heteroaromatischen o-Nitrocarbinolester-Gruppierungen enthalten, wie sie beispielsweise in der DE-C-21 50 691, der DE-B-23 09 062, der DE-A-29 22 746, der US-A-4 456 679, der US-A-4 465 760, der EP-A-101 586 oder der EP-A-141 389 beschrieben sind.

Vorzugsweise wird die lichtempfindliche Aufzeichnungsschicht der erfindungsgemäßen lichtempfindlichen Aufzeichnungselemente aus einem fotopolymerisierbaren oder fotovernetzbaren Gemisch gebildet, welches neben mindestens einem Fotoinitiator mindestens eine ethylenisch ungesättigte, fotopolymerisierbare oder fotovernetzbare Verbindung enthält, wobei es sich bei den ethylenisch ungesättigten, fotopolymerisierbaren oder fotovernetzbaren Verbindungen um Monomere, Oligomere oder auch fotopolymerisierbare bzw. fotovernetzbare Gruppen enthaltende Polymere handeln kann. In dem fotopolymerisierbaren Gemisch sind vorzugsweise nur solche ethylenisch ungesättigten, fotopolymerisierbaren Verbindungen, die zwei oder mehr ethylenisch ungesättigte, fotopolymerisierbare Doppelbindungen aufweisen, oder deren Mischungen mit ethylenisch ungesättigten, fotopolymerisierbaren Verbindungen mit nur einer ethylenisch ungesättigten, fotopolymerisierbaren Doppelbindung enthalten. Die fotopolymerisierbaren oder fotovernetzbaren Gemische können darüber hinaus auch noch weitere Bestandteile enthalten, wie insbesondere polymere Bindemittel, die mit den ethylenisch ungesättigten, fotopolymerisierbaren Verbindungen verträglich sind, thermische Polymerisationsinhibitoren, Füllstoffe, Weichmacher, sensitometrische Regler, Farbstoffe, fotochrome Verbindungen bzw. Systeme und dergleichen. Solche fotopolymerisierbaren Gemische für lichtempfindliche Aufzeichnungsschichten sind dem Fachmann hinreichend bekannt und in der einschlägigen Fachliteratur beschrieben.

Insbesondere vorteilhaft sind hierbei die mit wäßrigen Entwicklerlösungen entwickelbaren lichtempfindlichen fotopolymerisierbaren Aufzeichnungsschichten, d.h. solche lichtempfindlichen Aufzeichnungsschichten, die aus einem fotopolymerisierbaren Gemisch gebildet werden, welches in den wäßrigen Entwicklerlösungen löslich oder zumindest dispergierbar ist. Diese fotopolymerisierbaren Gemische enthalten mindestens ein gesättigtes polymeres Bindemittel und/oder ungesättigtes, fotopolymerisierbares bzw. fotovernetzbares polymeres Bindemittel, in aller Regel mindestens eine ethylenisch ungesättigte, fotopolymerisierbare niedermolekulare Verbindung sowie mindestens einen Fotopolymerisationsinitiator und gegebenenfalls weitere Zusatz-und/oder Hilfsstoffe, wie z.B. thermische Polymerisationsinhibitoren, Weichmacher, Verlaufshilfsmittel, weitere Farbstoffe, Füllstoffe und dergleichen. Als Beispiel hierfür seien die mit Wasser/ Alkohol-Entwicklerlösungen auswaschbaren fotopolymerisierbaren Gemische genannt, die als Bindemittel mindestens ein lösliches Polyamid oder Copolyamid, mindestens eine damit verträgliche, ethylenisch ungesättigte niedermolekulare Verbindung mit mindestens zwei fotopolymerisierbaren Doppelbindungen, mindestens einen Fotoinitiator sowie gegebenenfalls weitere Zusatz- und/oder Hilfsstoffe der genannten Art enthalten, wie sie z.B. in der FR-A-15 20 856 oder der DE-A-22 02 357 beschrieben sind.

Von besonderem Vorteil sind lichtempfindliche Aufzeichnungselemente mit einer wasserentwickelbaren lichtempfindlichen Aufzeichnungsschicht aus einem fotopolymerisierbaren Gemisch auf Basis von wasserlöslichen oder zumindest wasserdispergierbaren polymeren Bindemitteln, wie sie beispielsweise in den britischen Patentschriften 834 337, 1 233 883, 1 351 475, 786 119, 814 227, 835 849, den US-Patentschriften 3 801 328, 3 877 939 und 4 272 611, der DE-A-31 44 905, der EP-A-70 510, der EP-A-70 511 oder der EP-A-129 901 beschrieben sind. Als Beispiele für polymere Bindemittel, die in diesen fotopolymerisierbaren Gemischen enthalten sein können, seien die bekannten, in Wasser löslichen oder zumindest dispergierbaren Homo- oder Copolymerisate des N-Vinylpyrrolidons genannt, wobei als Comonomere beispielsweise die Vinylester, z.B. Vinylacetat, erwähnt seien. Auch verseifte N-Vinylpyrrolidon-Vinylester-Copolymerisate sind geeignet. Als vorteilhafte Bindemittel für diese fotopolymerisierbaren Gemische haben sich insbesondere Vinylalkohol-Polymerisate mit $-CH_2CH(OH)$-Struktureinheiten in der Polymerhauptkette erwiesen sowie deren in Wasser oder wäßrigen Lösungsmitteln lösliche oder dispergierbare Copolymerisate und Derivate, wie Ester, Ether oder Acetale. Besonders geeignet sind die bekannten teilverseiften Polyvinylester von aliphatischen Monocarbonsäuren mit 1 bis 4 C-Atomen, wie Polyvinylacetate oder Polyvinylpropionate, deren mittlerer Polymerisationsgrad im Bereich von etwa 200 bis 3000 liegt und deren Verseifungsgrad etwa 65 bis 98 Mol%, insbesondere etwa 80 bis 88 Mol%, beträgt. Auch Gemische von (teil)verseiften Vinylester-Polymerisaten oder -Copolymerisaten mit unterschiedlichem Polymerisationsgrad und/oder unterschiedlichem Verseifungsgrad können eingesetzt werden. Ferner seien als Polymere in diesem Zusammenhang auch die Umsetzungsprodukte von Vinylalkohol-Polymerisaten mit Acryl- und/oder Methacrylsäureanhydrid erwähnt, wobei diese Umsetzungsprodukte im allgemeinen 1 bis 12 Mol%, bezogen auf das Umsetzungsprodukt, an Acryloyl- und/oder Methacryloyl-Gruppen eingebaut enthalten, sowie auch die wasserlöslichen Umsetzungsprodukte von Vinylalkohol-Polymerisaten mit Ethylenoxid, wobei der Anteil der EthylenoxidEinheiten in dem oxethylierten Vinylalkohol-Polymerisat 5 bis 75 Gew.-%, insbesondere 10 bis 60 Gew.-%, betragen kann. Diese Umsetzungsprodukte von Vinylalkohol-Polymerisaten können als alleinige Polymer-Komponente in den fotopolymerisierbaren Gemischen enthalten sein, sie können aber auch in Mischung mit anderen verträglichen Polymeren, insbesondere den vorstehend erwähnten teilverseiften Polyvinylestern, vorliegen.

Sofern die fotopolymerisierbaren Gemische Polymere mit ethylenisch ungesättigten fotopolymerisierbaren bzw. fotovernetzbaren Gruppen enthalten, ist der Zusatz von fotopolymerisierbaren, ethylenisch ungesättigten niedermolekularen Verbindungen zu den fotopolymerisierbaren Gemischen nicht unbedingt notwendig, jedoch häufig vorteilhaft.

Als Beispiel für die fotopolymerisierbaren, ethylenisch ungesättigten niedermolekularen Verbindungen seien insbesondere die Acryloyl- und/oder Methacryloyl-Gruppen enthaltenden Monomeren und Oligomeren genannt, wozu u.a. gehören: Mono-, Di- und Poly(meth)acrylate, wie sie durch Veresterung von Acrylsäure oder Methacrylsäure mit ein- oder mehrwertigen niedermolekularen Alkoholen erhalten werden, wie z.B. die Di- und Tri (meth)acrylate von Ethylenglykol, Diethylenglykol, Triethylenglykol, Polyethylenglykolen mit einem Molekulargewicht bis etwa 500, 1,2-Propandiol, 1,3-Propandiol, Polypropylenglykolen mit einem Molekulargewicht bis etwa 500, 2, 2-Dimethylpropandiol, 1, 4-Butandiol, 1,1,1-Trimethylolpropan, Glycerin oder Pentaerythrit; ferner die Monoacrylate und Monomethacrylate solcher Diole oder Polyole, wie z.B. Ethylenglykol-mono-(meth)acrylat, Propandiol-mono-(meth)acrylat und Di-, Tri- oder Tetraethylenglykol-mono(meth)acrylat; die (Meth)acrylate von Monoalkanolen mit 1 bis 8 C-Atomen, (Meth)acrylamid und Mono- und Bis-(meth)acrylamide von aliphatischen oder aromatischen Diaminen mit 2 bis 8 C-Atomen, Derivate der (Meth)acrylamide, z.B. Hydroxymethyl-(meth)acrylamid oder insbesondere das Umsetzungsprodukt aus 2 Mol N-Hydroxymethyl-(meth)acrylamid und 1 Mol eines aliphatischen Diols, z.B. Ethylenglykol oder Propylenglykol; ferner monomere oder oligomere, urethangruppenhaltige Acrylat- oder Methacrylat-Verbindungen.

Die Auswahl der fotopolymerisierbaren, ethylenisch ungesättigten Verbindungen richtet sich in bekannter Weise nach den in den fotopolymerisierbaren Gemischen enthaltenen Polymeren, mit welchen sie verträglich sein sollen, und dem gewünschten Verwendungszweck der lichtempfindlichen Aufzeichnungselemente. Sie ist dem Fachmann geläufig und u.a. aus den vorstehend zitierten Druckschriften zu entnehmen. Die fotopolymerisierbaren Gemische enthalten die Polymeren und die fotopolymerisierbaren, ethylenisch ungesättigten niedermolekularen Verbindungen im allgemeinen in einer Menge von etwa 40 bis 90 Gew.-% bzw. von 10 bis 60 Gew.-%, jeweils bezogen auf die Summe von Polymerem und fotopolymerisierbarer, ethylenisch ungesättigter niedermolekularer Verbindung. Der Anteil der fotopolymerisierbaren, ethylenisch ungesättigten niedermolekularen Verbindungen kann in einzelnen Fällen auch größer oder kleiner sein. So ist es beispielsweise möglich, den Anteil der fotopolymerisierbaren, ethylenisch ungesättigten niedermolekularen Verbindungen unter 10 Gew.-% abzusenken, wenn in dem fotopolymerisierbaren Gemisch ungesättigte Polymere mit einem hinreichend hohen Gehalt an fotopolymerisierbaren bzw. fotovernetzbaren Doppelbindungen enthalten sind; er kann auch über 60 Gew.-% betragen, beispielsweise wenn fotopolymerisierbare Oligomere mitverwendet werden, solange die lichtempfindliche Aufzeichnungsschicht bei Raumtemperatur fest ist.

Als Fotopolymerisationsinitiatoren, die in den fotopolymerisierbaren Gemischen im allgemeinen in einer Menge von 0,05 bis 10 Gew.-%, insbesondere von 0,5 bis 5 Gew.-%, bezogen auf das fotopolymerisierbare Gemisch, enthalten sind, kommen die bekannten und üblichen, durch aktinisches Licht im Wellenlängenbereich von 300 bis 400 nm aktivierbarem Fotopolymerisationsinitiatoren in Betracht. Beispielhaft hierfür seien genannt: Benzoin, Benzoinether, insbesondere Benzoinalkylether, substituierte Benzoine, Alkylether von substituierten Benzoinen, wie z.B. $\alpha$-Methylbenzoinalkylether oder $\alpha$-Hydroxymethylbenzoinalkylether; Benzil, Benzilketale, wie insbesondere Benzildimethylketal; die als Fotoinitiator bekannten und wirksamen Acylphosphinoxid-Verbindungen, wie z.B. 2, 4, 6-Trimethylbenzoyldiphenylphosphinoxid; Benzophenon,

Derivate des Benzophenons, Michlers Keton, Derivate von Michlers Keton; Anthrachinon und substituierte Anthrachinone, arylsubstituierte Imidazole oder deren Derivate, wie z.B. 2,4,5-Triarylimidazoldimere und dergleichen. Wegen der Fluoreszenzeigenschaften der erfindungsgemäß in den lichtempfindlichen Aufzeichnungselementen enthaltenen Farbstoffe der allgemeinen Formel (I) ist es möglich und in vielen Fällen vorteilhaft, neben den durch aktinisches Licht im Wellenlängenbereich von 300 bis 400 nm aktivierbaren Fotoinitiatoren in den lichtempfindlichen Aufzeichnungsschichten auch noch solche Fotoinitiatoren oder fotoreaktive Verbindungen einzusetzen, die auf das von den Farbstoffen der allgemeinen Formel (I) ausgestrahlte Fluoreszenzlicht ansprechen und hierdurch aktivierbar sind. Dadurch kann in den Lagen oder Schichtdickenbereichen der lichtempfindlichen Aufzeichnungsschicht, in denen bei Bestrahlung des lichtempfindlichen Aufzeichnungselements mit aktinischem Licht im Wellenlängenbereich von 300 bis 400 nm das von den Farbstoffen der allgemeinen Formel (I) ausgestrahlte Fluoreszenzlicht wirksam ist, eine zusätzliche Fotoreaktion bewirkt und dadurch insbesondere Einfluß auf die Reliefstruktur genommen werden. Sind die Farbstoffe der allgemeinen Formel (I) in den lichtempfindlichen Aufzeichnungselementen, z.B. in einer Zwischenschicht zwischen Träger und lichtempfindlicher Aufzeichnungsschicht und/oder einer dem Träger benachbarten Lage der lichtempfindlichen Aufzeichnungsschicht enthalten, so kann durch die Mitverwendung der auf das Fluoreszenzlicht ansprechenden Fotoinitiatoren beispielsweise eine stärkere Versockelung der Reliefelemente in den mit den lichtempfindlichen Aufzeichnungselementen hergestellten Relief- oder Druckformen erzielt werden. Vorzugsweise sind die auf das Fluoreszenzlicht ansprechenden Fotoinitiatoren bzw. fotoreaktiven Verbindungen in der lichtempfindlichen Aufzeichnungsschicht in unmittelbarer Nähe bzw. Nachbarschaft zum Träger bzw. gegebenenfalls vorhandenen Zwischenschichten, d.h. in den von der äußeren Oberfläche her gesehen unteren Bereichen der lichtempfindlichen Aufzeichnungsschicht, enthalten.

Weiterhin können die fotopolymerisierbaren Gemische für die lichtempfindlichen Aufzeichnungsschichten übliche und an sich bekannte Zusatz- und/ oder Hilfsstoffe der vorstehend genannten Art in den hierfür üblichen und bekannten, wirksamen Mengen enthalten. Insbesondere sind die Komponenten der lichtempfindlichen Aufzeichnungsschicht nach Art und Menge so aufeinander abgestimmt, daß die lichtempfindliche Aufzeichnungsschicht der erfindungsgemäßen lichtempfindlichen Aufzeichnungselemente bei Raumtemperatur fest ist.

Die erfindungsgemäßen lichtempfindlichen Aufzeichnungselemente können, insbesondere wenn sie zur Herstellung von Druck- oder Reliefformen dienen, zwischen dem dimensionsstabilen Träger und der lichtempfindlichen Aufzeichnungsschicht mindestens eine Zwischenschicht enthalten, die insbesondere als Haftschicht und/oder Lichthofschutzschicht ausgebildet ist. Bei diesen Zwischenschichten handelt es sich im allgemeinen um polymere Schichten, die lichtempfindlich oder auch nicht-lichtempfindlich sein können. Haftschichten enthalten im allgemeinen ein Polymer, welches dem polymeren Bindemittel in der lichtempfindlichen Aufzeichnungsschicht entspricht oder diesem zumindest ähnlich ist. Als haftvermittelnde Zwischen-schichten kommen beispielsweise solche auf Basis von Polyurethanen, Polyvinylalkoholen oder Polyvinylalkohol-Derivaten, Polyamiden, Epoxidharzen, Melamin-Formaldehyd-Harzen und ähnlichen in Betracht, wie sie u.a. in der DE-A-15 97 515, der US-A-3 877 939, der EP-A-53 258, der EP-A-53 260, der EP-A-2 321, der US-A-4 387 157, der US-A-4 355 093 oder US-A-4 357 414 beschrieben sind. Diese Zwischenschichten können neben den Polymeren auch polymerisierbare Monomere, wie beispielsweise Hydroxyalkyl(meth)acrylate oder Urethan(meth)acrylate, sowie auch einen Fotoinitiator enthalten.

Wenn die Zwischenschichten als Lichthofschutzschicht ausgebildet sind, um bei der bildmäßigen Belichtung der lichtempfindlichen Aufzeichnungsschicht eine übermäßig hohe und unerwünschte Reflexion des eingestrahlten aktinischen Lichtes durch den dimensionsstabilen Träger zu vermeiden, enthalten diese Zwischenschichten ferner Verbindungen, die Licht in dem aktinischen Wellenlängenbereich absorbieren, insbesondere die erfindungsgemäß einzusetzenden Farbstoffe der allgemeinen Formel (I) sowie daneben gegebenenfalls andere migrationsechte Farbstoffe und/oder Pigmente, insbesondere wenn diese ihre Absorptionsmaxima in einem anderen Wellenlängenbereich, z.B. über 400 nm, aufweisen.

Da die erfindungsgemäß in den lichtempfindlichen Aufzeichnungselementen enthaltenen Farbstoffe der allgemeinen Formel (I) nicht oder zumindest praktisch nicht migrieren und sich damit auch die Fotoeigenschaften der diese Farbstoffe der allgemeinen Formel (I) enthaltenden lichtempfindlichen Aufzeichnungselemente selbst bei langer Lagerung nicht ändern, ist es erfindungsgemäß möglich und zur Steuerung der Belichtungseigenschaften der lichtempfindlichen Aufzeichnungselemente bzw. der fotochemischen Prozesse hierin auch besonders vorteilhaft, wenn die in der lichtempfindlichen Aufzeichnungsschicht und gegebenenfalls vorhandenen Zwischenschichten erfindungsgemäß enthaltenen Farbstoffe der allgemeinen Formel (I) über die Dicke des Aufzeichnungselementes hinweg gesehen, d.h. von der äußeren Oberfläche der lichtempfindlichen Aufzeichnungsschicht in Richtung Träger, in abgestufter Konzentration enthalten sind. Da die Steuerung der fotochemischen Eigenschaften der lichtempfindlichen Aufzeichnungselemente nach

verschiedenen Prinzipien erfolgen kann, können dementsprechend auch die erfindungsgemäß in den lichtempfindlichen Aufzeichnungselementen enthaltenen Farbstoffe der allgemeinen Formel (I) in verschiedener Art in der lichtempfindlichen Aufzeichnungsschicht und gegebenenfalls vorhandenen Zwischenschichten enthalten sein.

So kann es beispielsweise zum einen erwünscht sein, bei der bildmäßigen Belichtung der lichtempfindlichen Aufzeichnungselemente die Intensität des von oben in die lichtempfindliche Aufzeichnungsschicht eingestrahlten aktinischen Lichtes in verschiedenen Schichttiefen in bestimmter Weise zu drosseln und so die durch das Licht angeregten Vorgänge je nach Eindringtiefe unterschiedlich abzuschwächen. Hierdurch werden beispielsweise Gestalt und Druckeigenschaften einer Hochdruck-oder Tiefdruckform deutlich beeinflußt. Zur Erreichung dieses Ziels können die erfindungsgemäß einzusetzenden Farbstoffe der allgemeinen Formel (I) in der lichtempfindlichen Aufzeichnungsschicht in einem Konzentrationsgefälle, d.h. in über die Schichtdicke der Aufzeichnungsschicht hinweg abgestufter Konzentration, enthalten sein. Dies kann beispielsweise dadurch bewirkt werden, daß die lichtempfindliche Aufzeichnungsschicht aus zwei oder mehr Lagen aufgebaut ist, die den oder die Farbstoffe der allgemeinen Formel (1) in unterschiedlichen Konzentrationen enthalten. Dabei kann in einer oder mehreren dieser Lagen der lichtempfindlichen Aufzeichnungsschicht die Farbstoffkonzentration auch gleich O sein, d.h. einzelne Lagen einer mehrlagig aufgebauten lichtempfindlichen Aufzeichnungsschicht brauchen keinen Farbstoff zu enthalten, wenn zumindest in einer Lage der mehrlagig aufgebauten lichtempfindlichen Aufzeichnungsschicht ein erfindungsgemäß einzusetzender Farbstoff der allgemeinen Formel (I) vorhanden ist. Dabei nimmt im allgemeinen die Farbstoffkonzentration in den einzelnen Lagen der mehrlagigen lichtempfindlichen Aufzeichnungsschicht entweder von der äußeren Oberfläche der lichtempfindlichen Aufzeichnungsschicht zum dimensionsstabilen Träger hin ab oder vorzugsweise umgekehrt auch zu. Das gleiche Prinzip kann auch mit einer einlagigen lichtempfindlichen Aufzeichnungsschicht realisiert werden, wenn in dieser lichtempfindlichen Aufzeichnungsschicht die erfindungsgemäß einzusetzenden Farbstoffe der allgemeinen Formel (I) mit einem von der äußeren Oberfläche der lichtempfindlichen Aufzeichnungsschicht zum dimensionsstabilen Träger hin verlaufenden Konzentrationsgradienten enthalten sind.

In anderen Fällen soll bei der bildmäßigen Belichtung der lichtempfindlichen Aufzeichnungselemente das in die lichtempfindliche Aufzeichnungsschicht eingestrahlte aktinische Licht beim Durchgang durch die lichtempfindliche Aufzeichnungsschicht möglichst wenig geschwächt werden. Gleichzeitig soll aber auch vermieden werden, insbesondere bei Einsatz von nicht-transparenten dimensionsstabilen Trägern, daß das bildmäßig eingestrahlte aktinische Licht durch Reflexion und/oder unkontrollierte Streuung am Träger oder in einer Zwischenschicht in Bereiche der lichtempfindlichen Aufzeichnungsschicht zurückgeworfen wird, die unbelichtet bleiben sollen. Bei der Herstellung von Hochdruckformen können sich Reflexion und Streuung in einer zu geringen Ausbildung der sogenannten Zwischentiefen bemerkbar machen, wodurch vielfach der Druckprozeß erheblich beeinträchtigt wird. In diesen Fällen enthält die lichtempfindliche Aufzeichnungsschicht die Farbstoffe nur in geringer Konzentration und sind die erfindungsgemäß einzusetzenden Farbstoffe der allgemeinen Formel (I) im Sockelbereich der lichtempfindlichen Aufzeichnungsschicht angeordnet. Dies erfolgt meist und am einfachsten dadurch, daß die erfindungsgemäß einzusetzenden Farbstoffe der allgemeinen Formel (I) in diesem Fall in einer Zwischenschicht zwischen dimensionsstabilem Träger und lichtempfindlicher Aufzeichnungsschicht eingearbeitet sind, die vorzugsweise unmittelbar benachbart zu der lichtempfindlichen Aufzeichnungsschicht angeordnet ist.

Selbstverständlich ist es auch möglich, daß die erfindungsgemäß in den lichtempfindlichen Aufzeichnungselementen enthaltenen Farbstoffe der allgemeinen Formel (I) sowohl in der lichtempfindlichen Aufzeichnungsschicht als auch einer oder mehreren gegebenenfalls vorhandenen Zwischenschichten enthalten sind, und zwar insbesondere in unterschiedlicher Konzentration in den einzelnen Schichten, wobei die Konzentration der Farbstoffe der allgemeinen Formel (I) in der oder den Zwischenschichten in aller Regel höher sein wird als die in der lichtempfindlichen Aufzeichnungsschicht. In diesem Fall können die Farbstoffe der allgemeinen Formel (I) in der lichtempfindlichen Aufzeichnungsschicht sowohl homogen verteilt sein als auch in über die Schichtdicke hinweg abgestufter Konzentration vorliegen. Bei lichtempfindlichen Aufzeichnungselementen, die mehrere Zwischenschichten zwischen dimensionsstabilem Träger und lichtempfindlicher Aufzeichnungsschicht aufweisen, ist es möglich, daß die erfindungsgemäß einzusetzenden Farbstoffe der allgemeinen Formel (I) in nur einer, mehreren oder auch allen dieser Zwischenschichten enthalten sind. Als vorteilhaft, aber keineswegs zwingend, hat es sich dabei erwiesen, wenn die erfindungsgemäß einzusetzenden Farbstoffe der allgemeinen Formel (I) in der der lichtempfindlichen Aufzeichnungsschicht unmittelbar benachbarten, d.h. an diese angrenzenden, Zwischenschicht enthalten sind. Darüber hinaus sind natürlich mit den erfindungsgemäß einzusetzenden Farbstoffen der allgemeinen Formel (I) die verschiedensten Variationen der vorstehend beschriebenen Einfärbungen der lichtempfindlichen Aufzeichnungselemente möglich, ebenso wie auch andere Prinzipien inhomogener oder diskontinuierlicher Einfärbung der

lichtempfindlichen Aufzeichnungsschichten und/oder gegebenenfalls vorhandener Zwischenschichten.

Gemäß einer besonderen Ausführungsform der Erfindung können die lichtempfindlichen Aufzeichnungselemente neben den Farbstoffen der allgemeinen Formel (I) in der lichtempfindlichen Aufzeichnungsschicht und/oder gegebenenfalls vorhandenen Zwischenschichten noch weitere migrationsbeständige Farbstoffe enthalten, und zwar insbesondere solche, die Absorptionsmaxima oberhalb von 400 nm besitzen und sich somit bezüglich des Absorptionsverhaltens mit den Farbstoffen der allgemeinen Formel (I) ergänzen. Zu solchen migrationsechten Farbstoffen, die neben den erfindungsgemäß einzusetzenden Farbstoffen der allgemeinen Formel (I) in den lichtempfindlichen Aufzeichnungselementen enthalten sein können, gehören insbesondere Sulfogruppen enthaltende Azo- oder Azoxifarbstoffe, beispielsweise der allgemeinen Formel (XIX)

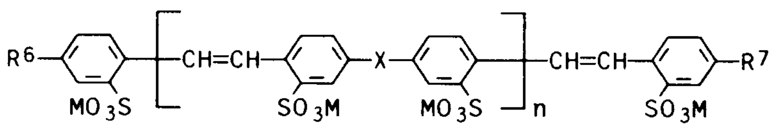

(XIX)

worin bedeuten:

- X eine Azo- oder Azoxigruppierung,
- M ein Wasserstoffatom bzw. Proton, ein Alkalimetall-Kation, das Ammonium- oder ein Amin-Kation,
- $R^6$, $R^7$ gleich oder verschieden und unabhängig voneinander, eine $-NO_2$-Gruppe, eine $NH_2$-Gruppe, eine $-NHCOR^8$-Gruppe (mit $R^8$ = einem Wasserstoffatom, einem gegebenenfalls substituierten Alkylrest, einem gegebenenfalls substituierten Cycloalkylrest, einem gegebenenfalls substituierten Phenylrest, einem Alkoxyrest, einem Phenoxyrest, einem 5- oder 6-gliedrigen heteroaromatischen Rest oder eine -COOH-Gruppe), eine $-NHSO_2R^9$-Gruppe (mit $R^9$ = einem Alkyl- oder Phenylrest) oder eine $-N=N-R^{10}$-Gruppe (mit $R^{10}$ = dem Rest einer Kupplungskomponente),
- n eine ganze Zahl von 1 bis 6 und für den Fall, daß $R^6$ und/oder $R^7$ eine $-N=N-R^{10}$-Gruppe darstellen, auch 0.

In der allgemeinen Formel (XIX) stehen $R^6$ und $R^7$ vorzugsweise für eine $-NHCOR^8$-Gruppe, wobei $R^8$ einen Alkyl- oder gegebenenfalls substituierten Phenylrest darstellt, für eine $-N=N-R^{10}$-Gruppe, worin $R^{10}$ den Rest einer wasserlöslichen Kupplungskomponente darstellt, oder insbesondere für eine $-NO_2$-Gruppe oder $-NH_2$-Gruppe und n für eine ganze Zahl im Bereich von 1 bis 3, wobei n für den Fall, daß wenigstens einer der Reste $R^6$ oder $R^7$ eine $-N=N-R^{10}$-Gruppe darstellt, auch 0 sein kann. Farbstoffe der allgemeinen Formel (XIX) sind beispielsweise in der DE-A-24 05 855, der DE-A-30 07 077 und der EP-AQ-13 750 beschrieben oder können nach den dort genannten Verfahren hergestellt werden. Insbesondere gehören hierzu auch die Farbstoffe, wie sie in an sich bekannter Weise durch Selbstkondensation von 5-Nitro-o-toluolsulfonsäure hergestellt werden können, und C.I. Direct Yellow 11 (C. I. 40 000). Diese weiteren migrationsechten Farbstoffe können in den lichtempfindlichen Aufzeichnungselementen in direkter Mischung mit den erfindungsgemäß einzusetzenden Farbstoffen der allgemeinen Formel (I), d.h. mit diesen zusammen in dieselbe Schicht bzw. Schichtlage des lichtempfindlichen Aufzeichnungselements vorliegen, oder aber auch getrennt hiervon in einer anderen Schicht oder Schichtlage, vorzugsweise ebenfalls, wie vorstehend erläutert, in abgestufter Konzentration, enthalten sein.

Die erfindungsgemäßen lichtempfindlichen Aufzeichnungselemente können ferner auf der äußeren, d.h. dem dimensionsstabilen Träger abgewandten Oberfläche der lichtempfindlichen Aufzeichnungsschicht auch noch eine Deckschicht, die vorzugsweise in dem gleichen Entwicklerlösungsmittel löslich ist wie die lichtempfindliche Aufzeichnungsschicht, und/oder eine Deckfolie, die von der lichtempfindlichen Aufzeichnungsschicht bzw. einer gegebenenfalls vorhandenen Deckschicht abziehbar ist, enthalten. Solche Deckschichten bzw. Deckfolien dienen vor allem dem Schutz der lichtempfindlichen Aufzeichnungsschicht bei der Lagerung und Handhabung der lichtempfindlichen Aufzeichnungselemente sowie gegebenenfalls als SauerStoffsperre, insbesondere wenn die lichtempfindliche Aufzeichnungsschicht aus einem fotopolymerisierbaren Gemisch gebildet wird. Als besonders geeignet haben sich z.B. Deckschichten bzw. -folien aus Polyvinylalkoholen oder Polyvinylalkohol-Derivaten, Polyolefinen, Polyestern oder dergleichen erwiesen.

Die Herstellung der erfindungsgemäßen lichtempfindlichen Aufzeichnungselemente kann in an sich üblicher und bekannter Weise erfolgen. Beispielsweise kann eine homogene Mischung der die lichtempfindliche Aufzeichnungsschicht bildenden Komponenten hergestellt und diese schichtförmig auf den - gegebenenfalls mit einer oder mehreren Zwischenschichten versehenen - dimensionsstabilen Träger aufgebracht

werden. Das Mischen der Komponenten der lichtempfindlichen Aufzeichnungsschicht kann in einer geeigneten Mischvorrichtung, z.B. einem Mischer oder Extruder, oder auch in Lösung in einem geeigneten Lösungsmittel oder Lösungsmittelgemisch erfolgen. Das Beschichten des - gegebenenfalls mit der oder den Zwischenschichten versehenen - dimensionsstabilen Trägers mit dem lichtempfindlichen Aufzeichnungsmaterial kann beispielsweise durch Auflaminieren oder Aufkaschieren einer vorgefertigten Schicht aus dem lichtempfindlichen Aufzeichnungsmaterial oder auch aus Lösung durch Gießen, Tauchen, Sprühen oder andere bekannte Auftragstechniken und anschließendes Abdampfen des Lösungsmittels erfolgen. Bei mehrlagigen lichtempfindlichen Aufzeichnungsschichten können die einzelnen Lagen entweder nacheinander durch Auftrag aus Lösung übereinander angeordnet werden, es ist aber auch möglich, die einzelnen Lagen der lichtempfindlichen Aufzeichnungsschicht vorzufertigen und dann anschließend in der gewünschten Reihenfolge, beispielsweise durch Kaschieren oder Laminieren, miteinander zu verbinden. Bei lichtempfindlichen Aufzeichnungselementen, die zwischen Träger und lichtempfindlicher Aufzeichnungsschicht eine oder mehrere Zwischenschichten enthalten, können diese Zwischenschichten ebenfalls in an sich bekannter Weise, beispielsweise durch Auftrag aus Lösung, durch Laminieren oder Kaschieren auf dem Träger aufgebracht werden. Bei photohärtbaren Zwischenschichten kann die Härtung und Vernetzung der Zwischenschicht nach dem Auftrag der lichtempfindlichen Aufzeichnungsschicht erfolgen; vorzugsweise wird in diesem Fall jedoch die Zwischenschicht erst ausgehärtet und dann die lichtempfindliche Aufzeichnungsschicht auf die zuvor gehärtete, fotovernetzte Zwischenschicht aufgebracht. Die erfindungsgemäß in den lichtempfindlichen Aufzeichnungselementen enthaltenen Farbstoffe der allgemeinen Formel (I) werden bei der Herstellung in den gewünschten Konzentrationen in die Materialien für die einzelnen Schichten bzw. - bei mehrlagigen lichtempfindlichen Aufzeichnungsschichten - für die einzelnen Lagen der Aufzeichnungsschicht eingearbeitet. Die Herstellung eines lichtempfindlichen Aufzeichnungselements mit einem Konzentrationsgradienten des Farbstoffs der allgemeinen Formel (I) in einer einlagigen lichtempfindlichen Aufzeichnungsschicht kann beispielsweise erfolgen, daß man den Farbstoff der allgemeinen Formel (I) aus einer einseitig aufgebrachten Lösung in die frisch aus Lösung gegossene, noch stark lösungsmittelhaltige lichtempfindliche Aufzeichnungsschicht, gegebenenfalls bei erhöhter Temperatur, eindiffundieren läßt. Auch durch Verwendung einer Mehrschichtengießvorrichtung, mittels der in einem Arbeitsgang zwei oder mehrere lichtempfindliche Schichten mit unterschiedlicher Farbstoffkonzentration, sonst aber gleicher Zusammensetzung gegossen werden können, läßt sich, bevor das Lösungsmittel im anschließenden Trockenvorgang entfernt wird, durch Diffusion ein Konzentrationsgradient des Farbstoffs aufbauen. Dieser Vorgang kann noch unterstützt werden durch bewußt erzeugte, partielle Vermischung benachbarter Schichten im Bereich der Grenzzonen. Letzteres ist selbstverständlich auch bei Coextrusion von zwei oder mehreren Schichten mit unterschiedlicher Farbstoffkonzentration möglich. Eine gegebenenfalls vorhandene Deckschicht und/oder Deckfolie kann nachträglich auf die lichtempfindliche Aufzeichnungsschicht aufgebracht werden, es ist jedoch auch möglich, zunächst die lichtempfindliche Aufzeichnungsschicht auf der Deckfolie oder Deckschicht, beispielsweise durch Auftrag aus Lösung, herzustellen und dann den so vorgefertigten Verbund aus Deckschicht bzw. -folie und lichtempfindlicher Aufzeichnungsschicht mit dem Träger, der gegebenenfalls zuvor mit der oder den Zwischenschichten versehen worden ist, zu verbinden.

Die erfindungsgemäßen lichtempfindlichen Aufzeichnungselemente eignen sich beispielsweise zur Herstellung von bildmäßig strukturierten Resistschichten und Resistmustern sowie insbesondere zur Herstellung von Druckund Reliefformen. Die erfindungsgemäßen lichtempfindlichen Aufzeichnungselemente lassen sich in bekannter Weise zu Druckklischees verarbeiten, indem sie nach einer eventuellen Vorbelichtung durch eine geeignete Bildvorlage bildmäßig mit aktinischem Licht belichtet und anschließend, beispielsweise durch Auswaschen mit einem geeigneten Entwicklerlösungsmittel, entwickelt werden. Anschließend können die so hergestellten Druckoder Reliefformen bzw. Resistmuster noch einer Nachbehandlung unterzogen werden, wozu insbesondere die Trocknung und/oder eine nicht-bildmäßige Nachbelichtung gehören. Zur Vorbelichtung, Bildbelichtung und Nachbelichtung eignen sich die üblichen, aktinische Strahlung, insbesondere im Wellenlängenbereich von etwa 300 bis 400 nm, emittierenden Lichtquellen, wie UV-Fluoreszenzröhren, Quecksilberhoch-, -mittel- oder -niederdruckstrahler, superaktinische Leuchtstoffröhren, Xenon-Impulslampen, UV-Laser und ähnliche. Die erfindungsgemäßen lichtempfindlichen Aufzeichnungselemente zeichnen sich durch ihre guten und vorteilhaften Fotoeigenschaften aus, die auch bei langer Lagerung nicht verändert oder beeinträchtigt werden. Mit den erfindungsgemäßen lichtempfindlichen Aufzeichnungselementen können bildmäßige Vorlagen exakt und vorlagengetreu reproduziert werden, wobei die Belichtungseigenschaften und Strukturen der erhaltenen Reliefs einfach und in gewünschter Weise eingestellt werden können. Auf Grund der fluoreszierenden Eigenschaften der erfindungsgemäß einzusetzenden Farbstoffe der allgemeinen Formel (I) eignen sich die diese Farbstoffe der allgemeinen Formel (I) enthaltenden lichtempfindlichen Aufzeichnungselemente insbesondere zur Herstellung von Druck- und Reliefformen mit speziell eingestellten Reliefstrukturen.

Die Erfindung wird durch die nachfolgenden Beispiele näher erläutert. Die in den Beispielen genannten Teile und Prozente beziehen sich, sofern nicht anders angegeben, auf das Gewicht.

Beispiele 1 bis 6 und Vergleichsversuche A und B

Auf Aluminiumbleche wurden aus Lösung Mischungen aus 98,5 % eines teilverseiften Polyvinylacetats (Verseifungsgrad 82 Mol%; Molekulargewicht ca. 25000) und 1,5 % des jeweiligen, in der nachfolgenden Tabelle angegebenen Farbstoffs schichtförmig so aufgetragen, daß nach dem Trocknen bei 100 bis 150 °C eine 10 µm starke Lichthofschutzschicht resultierte.

Zur Herstellung einer fotopolymerisierbaren, lichtempfindlichen Aufzeichnungsschicht wurden zu einer Lösung von 222 Teilen eines teilverseiften Polyvinylacetats (Verseifungsgrad 83 Mol%; $\overline{M}_w$: ca. 30000) und 95 Teilen eines teilverseiften Polyvinylacetats, das 22 % Polyoxyethylensegmente gebunden enthielt, ($\overline{M}_w$: 25000 bis 30000) in 318 Teilen Wasser eine Lösung von 48 Teilen Butandiol-1,4-dimethacrylat, 3,8 Teilen 2, 4, 6-Trimethylbenzoyl-diphenylphosphinoxid und 1,0 Teilen 2,6-Di-t.-butyl-p-kresol in 281 Teilen 2-Hydroxyethylmethacrylat zugesetzt. Die so erhaltene Lösung wurde filtriert und entgast und dann zu einer lichtempfindlichen, fotopolymerisierbaren Schicht gegossen, die nach dem Trocknen ca. 500 µm stark war.

Die so hergestellte lichtempfindliche, fotopolymerisierbare Schicht wurde unter einem Druck von 1 $N/cm^2$ auf die auf den Aluminiumblechen befindlichen Lichthofschutzschichten aufkaschiert. Die so erhaltenen lichtempfindlichen Aufzeichnungselemente wurden bei Raumtemperatur gelagert, wobei nach 7 bzw. 250 Tagen Lagerung das Eindiffundieren der verschiedenen Farbstoffe in die lichtempfindlichen, fotopolymerisierbaren Schichten visuell begutachtet wurde. Die Ergebnisse sind ebenfalls in der Tabelle wiedergegeben. Wie sich hieraus ersehen läßt, war bei den erfindungsgemäß einzusetzenden Farbstoffen keine bzw. praktisch keine Migration erkennbar, wohingegen andere Sulfogruppen enthaltende Farbstoffe, wie sie im Stand der Technik für lichtempfindliche Aufzeichnungselemente empfohlen werden, bereits nach kurzer Lagerung in starkem Ausmaß in die fotopolymerisierbare, lichtempfindliche Aufzeichnungsschicht gewandert sind.

Tabelle

| Beispiel/ Vergleichsversuch | Farbstoff | Migration in die fotopolymerisierbare Aufzeichnungsschicht nach | |
|---|---|---|---|
| | | 7 Tagen | 250 Tagen |
| 1 | Verbindung der Formel (11) | äußerst gering | äußerst gering |
| 2 | Verbindung der Formel (III) | keine | keine |
| 3 | Verbindung der Formel (IV) | praktisch keine | praktisch keine |
| 4 | Verbindung der Formel (IV) | äußerst gering | äußerst gering |
| 5 | Verbindung der Formel (XII) | praktisch keine | praktisch keine |
| 6 | Verbindung der Formel (XVII) | praktisch keine | praktisch keine |
| A | C.I.Acid Black 1 (C.I. 20 470) | sehr stark | |
| B | C.I.Acid Violet 19 (C.I. 42 685) | sehr stark | |

## Patentansprüche

**1.** Lichtempfindliches Aufzeichnungselement, insbesondere für die Herstellung von Druck-, Reliefformen oder Resistmustern, mit

(a) einem dimensionsstabilen Träger,
(b) einer auf dem Träger aufgebrachten festen, lichtempfindlichen Aufzeichnungsschicht,
sowie gegebenenfalls
(c) einer oder mehreren Zwischenschichten zwischen dem Träger und der lichtempfindlichen Aufzeichnungsschicht,

welches zumindest in der lichtempfindlichen Aufzeichnungsschicht mindestens eine lichtabsorbierende, nicht-reaktive Verbindung enthält, dadurch gekennzeichnet, daß in der lichtempfindlichen Aufzeichnungsschicht in über die Schichtdicke hinweg abgestufter Konzentration als lichtabsorbierende, nicht-reaktive Verbindung mindestens eine Verbindung der allgemeinen Formel (I)

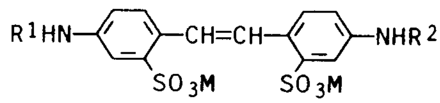

(I)

enthalten ist, wobei in der allgemeinen Formel (I) bedeuten

M: ein Wasserstoffatom bzw. Proton, ein Alkalimetall-Kation, das Ammonium- oder ein Amin-Kation und

$R^1$ $R^2$: gleich oder verschieden, jeweils einen substituierten s-Triazinring.

**2.** Lichtempfindliches Aufzeichnungselement nach Anspruch 1, dadurch gekennzeichnet, daß es als lichtabsorbierende, nicht-reaktive Verbindung mindestens eine Verbindung der allgemeinen Formel (I) enthält, worin M für ein Wasserstoffatom bzw. Proton steht.

**3.** Lichtempfindliches Aufzeichnungselement nach einem der Ansprüche 1 oder 2, dadurch gekennzeichnet, daß es als lichtabsorbierende, nicht-reaktive Verbindung mindestens eine Verbindung der allgemeinen Formel (I) enthält, worin die Reste $R^1$ und $R^2$, jeder für sich, für einen s-Triazinring stehen, der durch wenigstens eine $NH_2$-Gruppe und/ oder substituierte Amino-Gruppe substituiert ist.

**4.** Lichtempfindliches Aufzeichnungselement nach Anspruch 3, dadurch gekennzeichnet, daß es als lichtabsorbierende, nicht-reaktive Verbindung mindestens eine Verbindung der allgemeinen Formel (I) enthält, worin der den Rest $R^1$ bzw. $R^2$ bildende s-Triazinring durch wenigstens eine Phenylamino- oder Naphthylamino-Gruppe substituiert ist, wobei der Phenyl- bzw. Naphthylrest, insbesondere durch Alkyl- und/oder -$SO_3M$-Reste, substituiert sein kann.

**5.** Lichtempfindliches Aufzeichnungselement gemäß einem der Ansprüche 1 bis 4, dadurch gekennzeichnet, daß es als lichtabsorbierende, nichtreaktive Verbindung eine Verbindung der allgemeinen Formel (I) enthält, worin die Reste $R^1$ bzw. $R^2$ jeweils einen s-Triazinring, der zwei substituierte Amino-Reste aufweist, darstellen.

**6.** Lichtempfindliches Aufzeichnungselement nach Anspruch 5, dadurch gekennzeichnet, daß es als lichtabsorbierende, nicht-reaktive Verbindung mindestens eine Verbindung der allgemeinen Formel (I) enthält, worin die Reste $R^1$ und $R^2$, jeder für sich, einen s-Triazinring darstellen, der sowohl mit einer Dialkylamino- oder Bis(hydroxyalkyl)amino-Gruppe als auch mit einer gegebenenfalls substituierten Arylaminogruppe substituiert ist.

**7.** Lichtempfindliches Aufzeichnungselement nach einem der Ansprüche 1 bis 6, dadurch gekennzeichnet, daß die lichtempfindliche Aufzeichnungsschicht mehrlagig ausgebildet ist und die lichtabsorbierende, nicht-reaktive Verbindung in benachbarten Lagen der lichtempfindlichen Aufzeichnungsschicht in unterschiedlichen Konzentrationen enthalten ist, wobei die Konzentration in einzelnen Lagen auch 0 sein kann.

**8.** Lichtempfindliches Aufzeichnungselement nach einem der Ansprüche 1 bis 7, dadurch gekennzeichnet, daß es mindestens eine Zwischenschicht aufweist, in der die lichtabsorbierende, nicht-reaktive Verbindung in unterschiedlicher Konzentration als in der lichtempfindlichen Aufzeichnungsschicht enthalten ist.

**9.** Lichtempfindliches Aufzeichnungselement nach einem der Ansprüche 1 bis 8, dadurch gekennzeichnet, daß die Konzentration der lichtabsorbierenden, nicht-reaktiven Verbindung über die Dicke des Aufzeichnungselementes hinweg vom Träger zur äußeren Oberfläche der lichtempfindlichen Aufzeichnungsschicht hin abnimmt.

**10.** Lichtempfindliches Aufzeichnungselement nach einem der Ansprüche 1 bis 9, dadurch gekennzeichnet, daß die lichtempfindliche Aufzeichnungsschicht aus einem fotopolymerisierbaren Gemisch gebildet wird, welches mindestens eine ethylenisch ungesättigte Verbindung und mindestens einen Fotoinitiator enthält.

**11.** Lichtempfindliches Aufzeichnungselement nach einem der Ansprüche 1 bis 10, dadurch gekennzeichnet, daß die lichtempfindliche Aufzeichnungsschicht wäßrig entwickelbar ist und mindestens ein in wäßrigen Entwicklerlösungen lösliches oder zumindest dispergierbares polymeres Bindemittel, mindestens eine ethylenisch ungesättigte, fotopolymerisierbare niedermolekulare Verbindung, die mit dem polymeren Bindemittel verträglich ist, und mindestens einen Fotopolymerisationsinitiator enthält.

**12.** Lichtempfindliches Aufzeichnungselement nach Anspruch 11, dadurch gekennzeichnet, daß die lichtempfindliche Aufzeichnungsschicht als polymeres Bindemittel ein Vinylalkoholpolymerisat oder ein Derivat eines Vinylalkoholpolymerisats enthält.

## Claims

**1.** A photosensitive recording element, in particular for the production of printing plates, relief plates or resist images, having

(a) a dimensionally stable base and

(b) a solid photosensitive recording layer applied on the base,

with or without

(c) one or more intermediate layers between the base and the photosensitive recording layer,

and containing one or more light-absorbing, unreactive compounds at least in the photosensitive recording layer, wherein the layer contains, as the light-absorbing, unreactive compound, in graduated concentration across the layer thickness, one or more compounds of the formula (I)

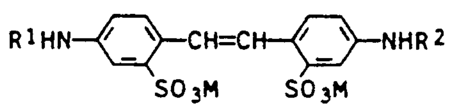

where in the formula (I) M is a hydrogen atom or proton, an alkali metal cation, the ammonium cation or an amine cation and $R^1$ and $R^2$ are identical or different and are each a substituted s-triazine ring.

**2.** A photosensitive recording element as claimed in claim 1, which contains, as the light-absorbing, unreactive compound, one or more compounds of the formula (I) where M is a hydrogen atom or proton.

**3.** A photosensitive recording element as claimed in claim 1 or 2, which contains, as the light-absorbing, unreactive compound, one or more compounds of the formula (I) where $R^1$ and $R^2$ are each an s-triazine ring which is substituted by one or more $NH_2$ groups and/or substituted amino groups.

**4.** A photosensitive recording element as claimed in claim 3, which contains, as the light-absorbing, unreactive compound, one or more compounds of the formula (I), wherein the s-triazine ring forming $R^1$ or $R^2$ is substituted by one or more phenylamino or naphthylamino groups, and the phenyl or naphthyl radical may be substituted, in particular by alkyl and/or $-SO_3M$.

**5.** A photosensitive recording element as claimed in any of claims 1 to 4, which contains, as the light-absorbing, unreactive compound, a compound of the formula (I) where $R^1$ and $R^2$ are each an s-triazine ring which has two substituted amino radicals.

**6.** A photosensitive recording element as claimed in claim 5, which contains, as the light-absorbing, unreactive compound, one or more compounds of the formula (I) where $R^1$ and $R^2$ are each an s-triazine ring which is substituted by both a dialkylamino or bis(hydroxyalkyl)amino group and an unsubstituted or substituted arylamino group.

**7.** A photosensitive recording element as claimed in any of claims 1 to 6, wherein the photosensitive recording layer has a plurality of strata and the light-absorbing, unreactive compound is present in adjacent strata of the photosensitive recording layer in different concentrations, and the concentration in individual layers may furthermore be 0.

8. A photosensitive recording element as claimed in any of claims 1 to 7, which has one or more intermediate layers in which the light-absorbing, unreactive compound is present in a concentration which differs from that in the photosensitive recording layer.

9. A photosensitive recording element as claimed in any of claims 1 to 8, wherein the concentration of the light-absorbing, unreactive compound decreases over the thickness of the recording element from the base toward the outer surface of the photosensitive recording layer.

10. A photosensitive recording element as claimed in any of claims 1 to 9, wherein the photosensitive recording layer consists of a photopolymerizable mixture which contains one or more ethylenically unsaturated compounds and one or more photoinitiators.

11. A photosensitive recording element as claimed in any of claims 1 to 10, wherein the photosensitive recording layer can be developed with an aqueous developer and contains one or more polymeric binders which are soluble or at least dispersible in aqueous developers, one or more ethylenically unsaturated, photopolymerizable, low molecular weight compounds which are compatible with the polymeric binder, and one or more photopolymerization initiators.

12. A photosensitive recording element as claimed in claim 11, wherein the photosensitive recording layer contains, as the polymeric binder, a vinyl alcohol polymer or a derivative of a vinyl alcohol polymer.

## Revendications

1. Elément d'enregistrement sensible à la lumière, en particulier pour la confection de formes d'impression, formes à reliefs ou modèles réserve (résist), comportant

(a) un support à stabilité dimensionnelle,
(b) une couche d'enregistrement solide, sensible à la lumière, qui est appliquée sur le support,

ainsi qu'éventuellement

(c) une ou plusieurs couches intermédiaires entre le support et la couche d'enregistrement sensible à la lumière,

qui contient, au moins dans la couche d'enregistrement sensible à la lumière, au moins un composé non réactif absorbant la lumière, caractérisé par le fait que dans la couche d'enregistrement sensible à la lumière, en concentration échélonnée à travers l'épaisseur de couche, est contenu, en tant que composé non réactif absorbant la lumière, au moins un composé de formule générale (I)

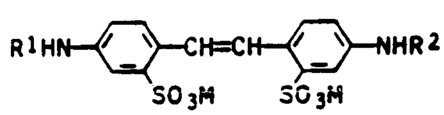 (I)

dans laquelle représentent :

M un atome d'hydrogène ou proton, un cation de métal alcalin, le cation ammonium ou un cation amine, et

$R^1$, $R^2$, identiques ou différents, chacun un cycle triazine-S substitué.

2. Elément d'enregistrement sensible à la lumière selon la revendication 1, caractérisé par le fait qu'il contient, comme composé non réactif absorbant la lumière, au moins un composé de formule générale (I) dans laquelle M est mis pour un atome d'hydrogène ou un proton.

3. Elément d'enregistrement sensible à la lumière selon l'une des revendications 1 ou 2, caractérisé par le fait qu'il contient, comme composé non réactif absorbant la lumière, au moins un composé de formule

générale (I) dans laquelle les restes $R^1$ et $R^2$, chacun pris séparément, sont mis pour un cycle triazine-S qui est substitué par au moins un groupe $NH_2$ et/ou un groupe amino substitué.

**4.** Elément d'enregistrement sensible à la lumière selon la revendication 3, caractérisé par le fait qu'il contient, comme composé non réactif absorbant la lumière, au moins un composé de formule générale (I) dans laquelle le cycle triazine-S formant le reste $R^1$ ou $R^2$ est substitué par au moins un groupe phénylamino ou naphtylamino, le reste phényle ou naphtyle pouvant être substitué en particulier par des restes alkyle et/ou - $SO_3M$.

**5.** Elément d'enregistrement sensible à la lumière selon l'une des revendications 1 à 4, caractérisé par le fait qu'il contient, comme composé non réactif absorbant la lumière, un composé de formule générale (I) dans laquelle les restes $R^1$ ou $R^2$ représentent, chacun, un cycle triazine-S présentant deux restes amino substitués.

**6.** Elément d'enregistrement sensible à la lumière selon la revendication 5, caractérisé par le fait qu'il contient , comme composé non réactif absorbant la lumière, au moins un composé de formule générale (I) dans laquelle les restes $R^1$ et $R^2$, chacun pris séparément, représentent un cycle triazine-S qui est substitué aussi bien par un groupe dialkylamino ou bis(hydroxyalkyl)amino que par un groupe arylamino éventuellement substitué.

**7.** Elément d'enregistrement sensible à la lumière selon l'une des revendications 1 à 6, caractérisé par le fait que la couche d'enregistrement sensible à la lumière est constituée de plusieurs couches et le composé non réactif absorbant à lumière est contenu, en concentrations différentes, dans des couches contiguës de la couche d'enregistrement sensible à la lumière, en concentrations différentes, la concentration, dans certaines couches, pouvant également être zéro.

**8.** Elément d'enregistrement sensible à la lumière selon l'une des revendications 1 à 7, caractérisé par le fait qu'il présente au moins une couche intermédiaire dans laquelle le composé non réactif absorbant la lumière est contenu en une concentration différant de celle de la couche d'enregistrement sensible à la lumière.

**9.** Elément d'enregistrement sensible à la lumière selon l'une des revendications 1 à 8, caractérisé par le fait que la concentration du composé non réactif absorbant la lumière décroit à travers l'épaisseur de l'élément d'enregistrement, depuis le support jusqu'à la surface extérieure de la couche d'enregistrement sensible à la lumière.

**10.** Elément d'enregistrement sensible à la lumière selon l'une des revendications 1 à 9, caractérisé par le fait que la couche d'enregistrement sensible à la lumière est constituée par un mélange photopolymérisable qui contient au moins un composé à insaturation éthylénique et au moins un photo-initiateur.

**11.** Elément d'enregistrement sensible à la lumière selon l'une des revendications 1 à 10, caractérisé par le fait que la couche d'enregistrement sensible à la lumière peut-être développée par un révélateur aqueux et contient au moins un liant polymère soluble ou au moins dispersable dans des solutions de révélateur aqueuses, au moins un composé photopolymérisable à bas poids moléculaire et à insaturation éthylénique, compatible avec le liant polymère, et au moins un initiateur de photopolymérisation.

**12.** Elément d'enregistrement sensible à la lumière selon la revendication 11, caractérisé par la fait que la couche d'enregistrement photosensible contient, comme liant polymère, un polymérisat d'alcool vinylique ou un dérivé d'un polymérisat d'alcool vinylique.